# FASCICULE DE BREVET EUROPEEN

(11) **EP 1 371 097 B1**
(45) Date de publication et mention de la délivrance du brevet: **19.11.2008**
(21) Numéro de dépôt: 02701406.7
(22) Date de dépôt: 04.02.2002
(51) Int. Cl.: H01L 29/06, H01L 27/02

(54) **STRUCTURE DE PROTECTION CONTRE DES PARASITES**
SCHUTZSTRUKTUR GEGEN STÖRUNGEN
STRUCTURE FOR PROTECTION AGAINST RADIO DISTURBANCES

(30) Priorité: 05.02.2001 FR 0101524
(43) Date de publication de la demande: 17.12.2003
(73) Titulaire: STMicroelectronics S.A., 92120 Montrouge (FR)
(72) Inventeur: BELOT, Didier, F-38140 Rives (FR)
(74) Mandataire: de Beaumont, Michel
(86) Numéro de dépôt international: PCT/FR2002/000423
(87) Numéro de publication internationale: WO 2002/063692

(56) Documents cités:
- EP-A- 0 081 396
- FR-A- 2 787 636
- US-A- 5 821 148

## Description

La présente invention concerne des circuits intégrés destinés à fonctionner à très haute fréquence et plus particulièrement de tels circuits dont certaines parties sont sensibles à des signaux parasites. Par exemple, dans le domaine des télécommunications et des téléphones portables, on souhaite intégrer sur une même puce des circuits logiques de traitement de signal et des circuits analogiques d'amplification, destinés à fonctionner à des fréquences très élevées, supérieures à 1 GHz, comprises par exemple dans la plage de 2 à 10 GHz. En particulier, il est généralement prévu un amplificateur analogique à faible bruit directement connecté à la sortie de l'antenne. Il importe d'éviter que le bruit résultant des commutations des signaux numériques affecte les entrées de l'amplificateur car alors ce bruit serait réinjecté dans le circuit avec un très fort gain.

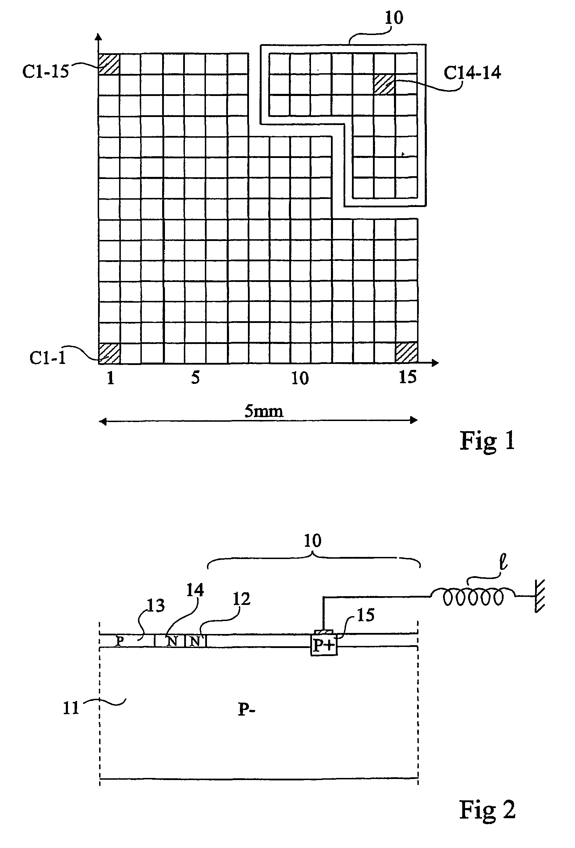

Pour tester la sensibilité au bruit d'un circuit intégré et de divers systèmes de protection, on peut utiliser une structure de test telle que celle représentée en figure 1. Dans cette structure de test, la puce est divisée en cases carrées. Par exemple, une partie de puce de 5 millimètres de côté est divisée en 15 X 15 cases. On forme un circuit susceptible d'émettre des signaux en créneaux dans la première case (case C1-1 de la première colonne et de la première rangée) et on étudie le signal haute fréquence recueilli dans les autres cases. Une partie du composant comprenant les cases les plus éloignées diagonalement de la case C1-1 est entourée d'une structure de protection 10. On teste la qualité de cette structure de protection en comparant le bruit recueilli dans la case C14-14 (quatorzième colonne, quatorzième rangée) disposée à l'intérieur de la structure de protection et le bruit recueilli par exemple dans la case C1-15 (première colonne, quinzième rangée) située sensiblement à la même distance de la case C1-1 que les cases disposées à l'intérieur de la structure de protection 10.

Comme l'illustre la vue en coupe partielle de la figure 2, on s'intéressera plus particulièrement au cas où la structure est formée sur un substrat de silicium monocristallin massif 11 faiblement dopé de type P (P⁻). On suppose que les divers composants du circuit intégré sont formés dans une partie supérieure de ce substrat, par exemple dans une couche épitaxiée faiblement dopée de type N dont une partie 12 est représentée à la limite de la structure de protection 10. Les divers composants sont par exemple formés directement dans cette couche épitaxiée (cas de certains transistors bipolaires) ou dans des caissons plus fortement dopés de type P (13) ou de type N (14) dans lesquels on trouvera notamment des transistors MOS à canal N et à canal P. La structure de protection est constituée d'un mur 15 fortement dopé de type P et relié à la masse.

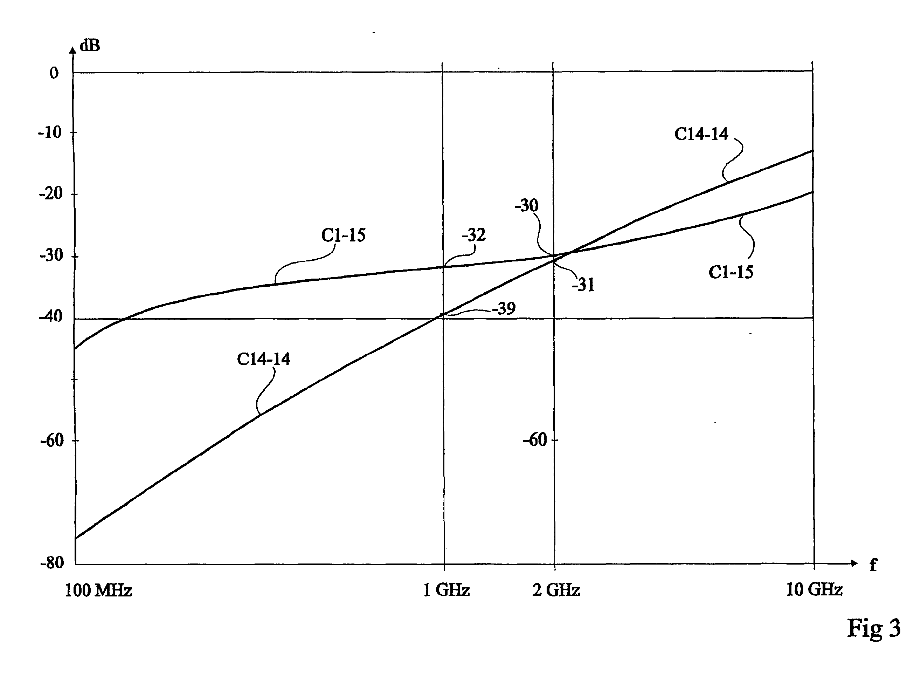

Une telle structure de protection s'avère efficace aux fréquences inférieures à 1 GHz. Toutefois, comme l'illustre la figure 3, la protection devient inefficace quand les fréquences augmentent. Ceci est dû en particulier au fait que la connexion entre le mur 15 fortement dopé et la masse comprend inévitablement une inductance 1 dont l'impédance augmente avec la fréquence.

La figure 3 représente l'atténuation en dB au niveau de la case C1-15 et au niveau de la case C14-14 d'un signal émis par la case C1-1, en fonction de la fréquence (en échelle logarithmique) entre 100 MHz et 10 GHz. Dans la case C1-15, on voit que cette atténuation diminue quand la fréquence augmente. Dans la case C14-14 (ou dans toute autre case située à l'intérieur de la structure, de protection 10) on voit que, jusqu'à une fréquence de l'ordre du gigahertz, l'atténuation est nettement plus importante que pour la case C1-15. Toutefois, pour des fréquences de l'ordre de 1 à 2 GHz, la pente de la courbe C14-14 change et l'atténuation procurée par le mur d'isolement 15 devient négligeable. On constate même que, pour des fréquences supérieures à 2 GHz, le mur d'isolement a un effet négatif, à savoir que l'atténuation du signal en provenance de la case C1-1 est moins importante dans la case C14-14 "protégée" par la structure d'isolement 10 que dans la case C1-15 qui elle n'est pas protégée.

On pourrait trouver diverses explications théoriques à ce phénomène qui en tout cas est certainement lié au fait que l'impédance de la connexion du mur d'isolement 15 à la masse devient élevée. Ainsi, dans l'art antérieur, on a essayé divers moyens pour réduire la valeur de cette impédance. L'un de ces moyens est d'utiliser un mode de montage des puces semiconductrices dit "flip chip" dans lequel les points de connexion sur la puce sont métallisés et revêtus de billes conductrices. Chaque bille conductrice est ensuite directement mise au contact d'une plage métallisée d'une carte de circuit imprimé à laquelle cette puce doit être connectée. On obtient ainsi des connexions à impédance beaucoup plus faible que dans le cas où les puces sont montées dans un boîtier et reliées aux pattes du boîtier par des fils. Toutefois, ceci n'a pas permis de résoudre complètement le-problème posé et n'a amélioré que partiellement les caractéristiques des structures de protection connues. FR-A-2 787 636 décrit un dispositif semiconducteur avec substrat de type BiCMOS à découplage de bruit.

Ainsi un objet de la présente invention est de prévoir une nouvelle structure de protection contre des parasites d'une zone d'un circuit intégré formé sur un substrat massif.

Pour atteindre cet objet, la présente invention prévoit une structure de protection d'une première zone d'une tranche semiconductrice comprenant un substrat d'un premier type de conductivité contre des parasites haute fréquence susceptibles d'être injectés à partir de composants formés dans la partie supérieure d'une deuxième zone de la tranche, comprenant un mur très fortement dopé du premier type de conductivité ayant sensiblement la profondeur de ladite partie supérieure. Le mur est divisé en trois bandes fortement dopées du premier type de conductivité séparées et encadrées par des bandes intermédiaires moyennement dopées du premier type de conductivité, la distance entre les bandes extrêmes fortement dopées étant de l'ordre de grandeur de l'épaisseur du substrat, les bandes fortement dopées étant recouvertes de métallisations.

Selon un mode de réalisation de la présente invention, le premier type de conductivité est le type P.

Selon un mode de réalisation de la présente invention, chacune des trois bandes fortement dopées de type P est divisée en segments successifs.

Selon un mode de réalisation de la présente invention, chaque segment est connecté à un plan de masse par l'intermédiaire d'un montage de type flip chip.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure de test d'un circuit intégré ;
la figure 2 représente une vue en coupe schématique et simplifiée d'une portion d'un circuit intégré au voisinage d'un mur d'isolement ;
la figure 3 représente l'atténuation en fonction de la fréquence en divers points d'une puce de circuit intégré ;
la figure 4 représente une vue de dessus partielle d'un mur d'isolement selon la présente invention ; et
la figure 5 représente une vue partielle en coupe d'un mur d'isolement selon la présente invention.

Conformément à l'usage dans le domaine de la représentation des composants semiconducteurs, les diverses vues en coupe et vues de dessus de composants ne sont pas tracées à l'échelle dans les diverses figures. Dans ces figures, de mêmes références désignent des éléments identiques ou similaires.

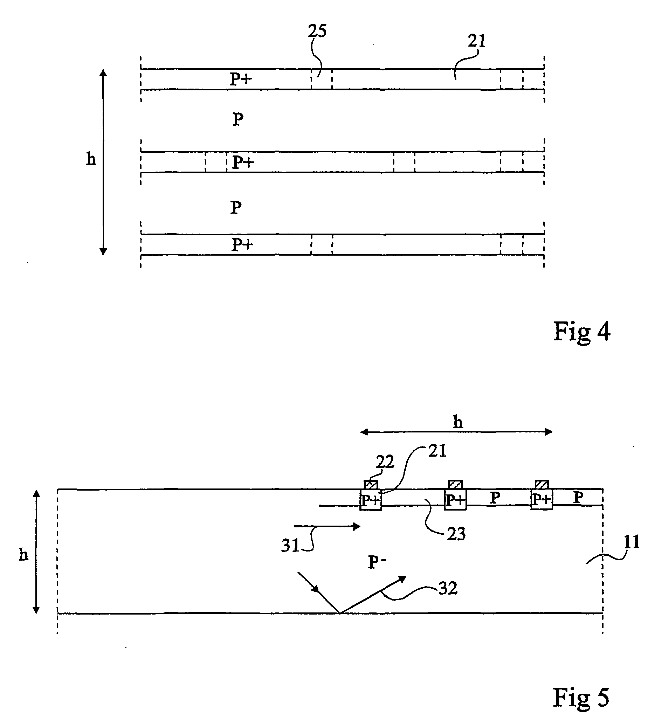

Comme le représentent les figures 4 et 5, la présente invention prévoit un mur d'isolement constitué de trois bandes parallèles 21 fortement dopées de type P⁺ et recouvertes de métallisations 22. Les métallisations 22 sont de préférence connectées indépendamment à un plan de masse, par exemple par un montage de type flip chip. Les bandes P⁺ 21 sont séparées par des régions 23 de type P d'un niveau de dopage intermédiaire entre le niveau de dopage du substrat et le niveau de dopage des régions P⁺. Des régions 23 de niveau de dopage intermédiaire sont de préférence également prévues à l'extérieur des bandes 21 extrêmes. La distance latérale entre les bandes 21 extrêmes a une valeur h du même ordre de grandeur que l'épaisseur h du substrat.

Si l'on considère en figure 5 que la partie à protéger est à droite de la figure et que la source d'ondes parasites haute fréquence est à gauche de la figure, la première bande P⁺ 21 captera les porteurs se déplaçant près de la surface du substrat et désignés par la référence 31. Si la face arrière du substrat est isolée, le substrat se conduira dans son ensemble comme un guide d'onde pour les hautes fréquences et les porteurs se déplaceront comme des ondes haute fréquence se réfléchissant sur la surface arrière. Les porteurs 32 réfléchis sur la face arrière au voisinage de la partie gauche de la structure d'isolement selon la présente invention frappent directement une bande 21 ou une région 23 de niveau de dopage intermédiaire et se déplaceront résistivement vers les bandes P⁺ 21.

Comme le représente la figure 3, on s'aperçoit qu'avec un mur triple selon la présente invention, on obtient pour une fréquence de 2 GHz, toutes choses égales d'ailleurs, un amortissement de -54 dB entre les cases C1-1 et C14-14 alors que cet amortissement était seulement de -31 dB avec un mur continu et que l'amortissement "naturel" apparaissant sur la courbe C1-15 était de l'ordre de -30 dB. L'expérience montre que ce résultat n'est pas obtenu avec une bande P⁺ unique de grande largeur.

Pour améliorer encore le fonctionnement du système selon la présente invention, au lieu d'utiliser des bandes 21 continues, on peut diviser ces bandes en segments successifs chaque segment étant revêtu d'une métallisation connectée indépendamment à un plan de masse. De préférence, les segments seront disposés en quinconce, c'est-à-dire que les intervalles entre deux segments de la bande médiane seront placées sensiblement au regard du milieu de segments des bandes extrêmes. Cette segmentation est illustrée à titre d'exemple par des zones 25 représentées entre deux pointillés en figure 4. On obtient alors pour une fréquence de 2 GHz, toutes choses égales d'ailleurs, un amortissement de -60 dB entre les cases C1-1 et C14-14.

A titre d'exemple, pour un substrat P d'une épaisseur de 350 µm, on pourra utiliser trois bandes P⁺ d'une largeur de 10µm espacées de 175 µm, ces bandes étant segmentées en segments d'une longueur de l'ordre de 175 µm, chaque segment étant muni d'un plot de contact, la distance entre plots étant de l'ordre de 200 µm.

## Revendications

1. Structure de protection d'une première zone d'une tranche semiconductrice comprenant un substrat (11) d'un premier type de conductivité contre des parasites haute fréquence susceptibles d'être injectés à partir de composants formés dans la partie supérieure d'une deuxième zone de la tranche, comprenant un mur très fortement dopé du premier type de conductivité ayant sensiblement la profondeur de ladite partie supérieure, **caractérisée en ce que** ledit mur est divisé en trois bandes (21) fortement dopées du premier type de conductivité séparées et encadrées par des bandes intermédiaires (23) moyennement dopées du premier type de conductivité, la distance entre les bandes extrêmes fortement dopées étant de l'ordre de grandeur de l'épaisseur du substrat, les bandes fortement dopées étant recouvertes de métallisations (22).

2. Structure selon la revendication 1, **caractérisée en ce que** le premier type de conductivité est le type P.

3. Structure selon la revendication 1, **caractérisée en ce que** chacune des trois bandes fortement dopées de type P (21) est divisée en segments successifs.

4. Structure de protection selon la revendication 3, **caractérisée en ce que** chaque segment est connecté à un plan de masse par l'intermédiaire d'un montage de type flip chip.

## Claims

1. A structure of protection of a first area of a semiconductor wafer including a substrate (11) of a first conductivity type against high-frequency noise likely to be injected from components formed in the upper portion of a second area of the wafer, including a very heavily-doped wall of the first conductivity type having substantially the depth of said upper portion, **characterized in that** said wall is divided into three heavily-doped strips (21) of the first conductivity type separated and surrounded by medium-doped intermediary strips (23) of the first conductivity type, the distance between the end heavily-doped strips being of the order of magnitude of the substrate thickness, the heavily-doped strips being covered with metallizations (22).

2. The structure of claim 1, **characterized in that** the first conductivity type is type P.

3. The structure of claim 1, **characterized in that** each of the three heavily-doped P-type strips (21) is divided into successive segments.

4. The protection structure of claim 3, **characterized in that** each segment is connected to a ground plane via a flip-chip assembly.

## Patentansprüche

1. Eine Struktur zum Schutz eines ersten Bereichs eines Halbleiter-Wafers einschließlich eines Substrats (11) eines Leitfähigkeitstyps gegen Hochfrequenzrauschen, das eine Wahrscheinlichkeit dahingehend besitzt, in den Bereich eingeführt zu werden und zwar von Bauteilen, die in dem oberen Teil eines zweiten Bereichs des Wafers ausgebildet sind, wobei die Struktur Folgendes aufweist: eine sehr stark dotierte Wand des ersten Leitfähigkeitstyps mit im wesentlichen der Tiefe des oberen Teils, **dadurch gekennzeichnet, dass** die Wand in drei stark dotierte Streifen (21) des ersten Leitfähigkeitstyps aufgeteilt sind, die getrennt und umgeben sind von mittel-dotierten Zwischenstreifen (23) des ersten Leitfähigkeitstyps, wobei der Abstand zwischen den Enden von stark dotierten Streifen in der Größenordnung der Substratdicke liegen, und wobei die stark dotierten Streifen mit Metallisierungen (22) abgedeckt sind.

2. Struktur nach Anspruch 1, **dadurch gekennzeichnet, dass** der ersten Leitfähigkeitstyp der P-Typ ist.

3. Struktur nach Anspruch 1, **dadurch gekennzeichnet, dass** jeder der drei stark dotierten P-Typ-Streifen (21) in aufeinanderfolgende Segmente unterteilt ist.

4. Die Schutzstruktur nach Anspruch 3, **dadurch gekennzeichnet, dass** jedes Segment mit Erde über eine Flip-Chip-Anordnung verbunden ist.
